Europäisches Patentamt

European Patent Office

Office européen des brevets

(19)

(11) **EP 0 786 091 B1**

(12) **EUROPÄISCHE PATENTSCHRIFT**

(45) Veröffentlichungstag und Bekanntmachung des Hinweises auf die Patenterteilung:
**25.11.1998  Patentblatt 1998/48**

(51) Int Cl.⁶: **G01R 15/24**

(86) Internationale Anmeldenummer:
**PCT/DE95/01332**

(21) Anmeldenummer: **95931914.6**

(22) Anmeldetag: **26.09.1995**

(87) Internationale Veröffentlichungsnummer:
**WO 96/11409 (18.04.1996 Gazette 1996/17)**

(54) **VERFAHREN UND VORRICHTUNG ZUM MESSEN EINER ELEKTRISCHEN WECHSELGRÖSSE MIT TEMPERATURKOMPENSATION**

PROCESS AND DEVICE FOR MEASURING AN ALTERNATING ELECTRIC QUANTITY WITH TEMPERATURE COMPENSATION

PROCEDE ET DISPOSITIF PERMETTANT DE MESURER UNE GRANDEUR ALTERNATIVE ELECTRIQUE A COMPENSATION THERMIQUE

(84) Benannte Vertragsstaaten:
**AT BE CH DE FR GB IT LI SE**

(30) Priorität: **10.10.1994  DE 4436181**

(43) Veröffentlichungstag der Anmeldung:
**30.07.1997  Patentblatt 1997/31**

(73) Patentinhaber: **SIEMENS AKTIENGESELLSCHAFT
80333 München (DE)**

(72) Erfinder:
- **BOSSELMANN, Thomas
  D-91054 Erlangen (DE)**
- **MENKE, Peter
  D-91054 Erlangen (DE)**

(56) Entgegenhaltungen:
EP-A- 0 390 581        EP-A- 0 410 234
EP-A- 0 586 226        DE-A- 4 304 762
US-A- 5 247 244

EP 0 786 091 B1

EP 0 786 091 B1

**Beschreibung**

Die Erfindung betrifft ein Verfahren und eine Vorrichtung zum Messen einer elektrischen Wechselgröße. Unter einer elektrischen Wechselgröße wird dabei eine zeitlich veränderliche elektrische Größe verstanden, deren Frequenzspektrum oberhalb einer vorbestimmten Frequenz liegt. Insbesondere kann die Wechselgröße ein elektrischer Wechselstrom, eine elektrische Wechselspannung oder auch ein elektrisches Wechselfeld sein.

Es sind optische Meßverfahren und Meßvorrichtungen zum Messen elektrischer Größen wie Strom, Spannung oder Feld bekannt, bei denen die Änderung der Polarisation von polarisiertem Meßlicht in einer Sensoreinrichtung in Abhängigkeit von der elektrischen Größe ausgewertet wird. Zum Messen eines elektrischen Stromes wird dabei der magnetooptische Faraday-Effekt ausgenutzt, zum Messen elektrischer Spannungen und Felder dagegen der elektrooptische Pockels-Effekt.

Unter dem Faraday-Effekt versteht man die Drehung der Polarisationsebene von linear polarisiertem Licht in Abhängigkeit von einem Magnetfeld. Der Drehwinkel ist dabei proportional zum Wegintegral über dem magnetischen Feld entlang des von dem Licht zurückgelegten Weges mit der Verdet-Konstanten als Proportionalitätskonstanten. Die Verdet-Konstante ist abhängig von dem Material, in dem das Licht verläuft, und von der Wellenlänge des Lichts. Zum Messen eines elektrischen Stromes in einem Stromleiter unter Ausnutzung des Faraday-Effekts ist in der Nähe des Stromleiters ein Faraday-Element als Sensoreinrichtung angeordnet, das aus einem optisch transparenten Material und im allgemeinen aus Glas besteht. Durch das Faraday-Element wird linear polarisiertes Licht geschickt. Das von dem elektrischen Strom erzeugte Magnetfeld bewirkt eine Drehung der Polarisationsebene des Lichtes in dem Faraday-Element um einen Drehwinkel, die von einer Auswerteeinheit als Maß für die Stärke des Magnetfeldes und damit für die Stärke des elektrischen Stromes ausgewertet werden kann. Im allgemeinen umgibt das Faraday-Element den Stromleiter, so daß das polarisierte Licht den Stromleiter in einem quasi geschlossenen Weg umläuft. In diesem Fall ist der Betrag des Polarisationsdrehwinkels in guter Näherung direkt proportional zur Amplitude des Meßstromes.

Aus WO 91/01501 ist eine optische Meßvorrichtung zum Messen eines elektrischen Stromes bekannt mit einem Faraday-Element, das als Teil einer optischen Monomode-Faser ausgebildet ist, die den Stromleiter in Form einer Meßwicklung umgibt.

Aus der EP-B-0 088 419 ist eine optische Meßvorrichtung zum Messen eines Stromes bekannt, bei der das Faraday-Element als massiver Glasring um den Stromleiter ausgebildet ist.

Unter dem elektrooptischen Pockels-Effekt versteht man die Änderung der Polarisation von polarisiertem Meßlicht in einem den Pockels-Effekt aufweisenden Material infolge einer in dem Material induzierten linearen Doppelbrechung, die im wesentlichen über den elektrooptischen Koeffizienten linear abhängig von einem das Material durchdringenden elektrischen Feld ist. Zum Messen eines elektrischen Feldes wird als Sensoreinrichtung ein Pockels-Element aus einem den Pockels-Effekt zeigenden Material in dem elektrischen Feld angeordnet. Zum Messen einer elektrischen Spannung wird die zu messende Spannung an zwei dem Pockels-Element zugeordnete Elektroden angelegt und das entsprechende, anliegende elektrische Feld gemessen. Durch das Pockels-Element wird polarisiertes Meßlicht gesendet, und die Änderung der Polarisation des polarisierten Meßlichts in Abhängigkeit von der zu messenden Spannung oder dem zu messen den Feld wird mit Hilfe eines Polarisationsanalysators ausgewertet.

Als Polarisationsanalysator können sowohl zur Strommessung mit einem Faraday-Element als auch zur Spannungsmessung mit einem Pockels-Element ein polarisierender Strahlteiler wie beispielsweise ein Wollaston-Prisma oder ein einfacher Strahlteiler mit zwei nachgeschalteten Polarisatoren vorgesehen sein (EP-B-0 088 419 und DE-C-34 04 608). Das durch die Sensoreinrichtung gelaufenen polarisierte Meßlicht wird in dem Analysator in zwei linear polarisierte Lichtteilstrahlen A und B mit verschiedenen und im allgemeinen senkrecht zueinander gerichteten Polarisationsebenen aufgespalten. Jedes dieser beiden Lichtteilsignale A und B wird von einem photoelektrischen Wandler jeweils in ein elektrisches Signal PA und PB umgewandelt.

Ein Problem bei allen optischen Meßverfahren und Meßvorrichtungen, bei denen die Polarisationänderung von polarisiertem Meßlicht in einem unter dem Einfluß der Meßgröße stehenden Sensorelement als Meßeffekt ausgenutzt wird, stellen die Empfindlichkeiten der optischen Materialien des Sensorelements und der optischen Übertragungsstrecken auf Temperaturänderungen oder auf mechanische Spannungen, die beispielsweise durch Verbiegen oder Vibrationen hervorgerufen werden, dar. Insbesondere die Temperaturempfindlichkeit führt bei Änderungen der Systemtemperatur zu einer unerwünschten Änderung des Arbeitspunktes und der Meßempfindlichkeit (Temperaturgang).

Zur Kompensation von Temperatureinflüssen sind bereits verschiedene Temperaturkompensationsverfahren bekannt.

In einem aus Proc. Conf. Opt. Fiber Sensors OFS 1988, New Orleans, Seiten 288 bis 291 und der zugehörigen US 4 755 665 bekannten Temperaturkompensationsverfahren für eine magnetooptische Meßvorrichtung zum Messen von Wechselströmen werden die beiden zu den Lichtteilsignalen A und B des Meßlichts gehörenden elektrischen Signale PA und PB jeweils in einem Filter in ihre Gleichstromanteile PA(DC) bzw. PB(DC) und ihre Wechselstromanteile PA(AC) bzw. PB(AC) zerlegt. Aus dem Wechselstromanteil PA(AC) bzw. PB(AC) und dem Gleichstromanteil PA(DC) bzw. PB(DC) wird für jedes Signal PA und PB zum Ausgleich von unterschiedlichen Intensitätsschwankungen (Dämp-

2

fungen) in den beiden Übertragungsstrecken für die Lichtsignale A und B der Quotient QA = PA(AC)/PA(DC) bzw. QB = PB(AC)/PB(DC) aus seinem Wechselstromanteil PA(AC) bzw. PB(AC) und seinem Gleichstromanteil PA(DC) bzw. PA(DC) gebildet. Aus jedem dieser beiden Quotienten QA und QB wird ein zeitlicher Mittelwert MW(QA) und MW(QB) gebildet, und aus diesen beiden Mittelwerten MW(QA) und MW(QB) wird schließlich ein Quotient Q = MW(QA)/MW (QB) gebildet. Im Rahmen eines Iterationsverfahrens wird durch Vergleich mit in einer Wertetabelle (Look-up-table) gespeicherten, geeichten Werten ein Korrekturfaktor K für den ermittelten Quotienten Q erhalten. Der um diesen Korrekturfaktor K korrigierte Wert Q*K wird als temperaturkompensierter Meßwert für einen zu messenden elektrischen Wechselstrom herangezogen. Mit diesem Verfahren kann die Temperaturempfindlichkeit auf etwa 1/50 herabgesetzt werden.

Aus EP-A-0 557 090 ist ein Temperaturkompensationsverfahren für eine optische Meßvorrichtung zum Messen magnetischer Wechselfelder bekannt, die den Faraday-Effekt ausnutzt und daher auch zum Messen elektrischer Wechselströme geeignet ist. Bei diesem bekannten Verfahren wird wieder das linear polarisierte Meßlicht nach Durchlaufen des Faraday-Elements in einem Analysator in zwei unterschiedlich linear polarisierte Lichtteilsignale A und B aufgespalten, und es wird zur Intensitätsnormierung für jedes der beiden zugehörigen elektrischen Signale PA und PB gesondert der Quotient QA = PA(AC)/PA(DC) bzw. QB = PB(AC)/PB(DC) aus seinem zugehörigen Wechselstromanteil PA(AC) bzw. PB(AC) und seinem zugehörigen Gleichstromanteil PA(DC) bzw. PB(DC) gebildet. Aus den beiden Quotienten QA und QB wird nun in einer Recheneinheit ein Meßsignal $M = 1/((\alpha/QA)-(\beta/QB))$ gebildet mit den reellen Konstanten $\alpha$ und $\beta$, die die Beziehung $\alpha+\beta = 1$ erfüllen. Dieses Meßsignal M wird als weitgehend unabhängig von durch Temperaturänderungen verursachten Änderungen der Verdet-Konstanten und der zirkularen Doppelbrechung im Faraday-Element beschrieben. Über eine Kompensation der temperaturinduzierten linearen Doppelbrechung ist nichts ausgesagt.

Aus der EP-A-0 586 226 ist ein entsprechendes Temperaturkompensationsverfahren für eine optische Meßvorrichtung zum Messen einer elektrischen Wechselspannung bekannt. Es ist eine optische Reihenschaltung aus einem Polarisator, einem $\lambda/4$-Plättchen, einem Pockels-Element und einem polarisierten Strahlteiler als Analysator optisch zwischen eine Lichtquelle und eine Auswerteeinheit geschaltet. Die Reihenfolge von $\lambda/4$-Plättchen und Pockels-Element in der optischen Reihenschaltung kann allerdings auch vertauscht sein. Das Meßlicht der Lichtquelle wird in dem Polarisator linear polarisiert und nach Durchlaufen des Pockels-Elements in dem Analysator in zwei Lichtteilsignale A und B mit unterschiedlichen Polarisationsebenen aufgespalten. Jedes dieser Lichtteilsignale A und B wird in ein entsprechendes elektrisches Intensitätssignal PA bzw. PB umgewandelt. Sodann wird zur Intensitätsnormierung für jedes dieser beiden elektrischen Intensitätssignale PA und PB der Quotient QA=PA(AC)/PA(DC) bzw. QB=PB (AC)/PB(DC) aus seinem zugehörigen Wechselsignalanteil PA(AC) bzw. PB(AC) und seinem zugehörigen Gleichsignalanteil PA (DC) bzw. PB(DC) gebildet. Aus den beiden intensitätsnormierten Quotienten QA und QB wird nun in einer Recheneinheit ein Meßsignal $M = 1/((\alpha/QA)-(\beta/QB))$ gebildet mit den reellen Konstanten $\alpha$ und $\beta$. Durch Anpassung dieser Konstanten $\alpha$ und $\beta$ wird das Meßsignal M weitgehend unabhängig von durch Temperaturänderungen verursachter linearer Doppelbrechung im $\lambda/4$-Plättchen.

In der Schrift US 5,247,244 wird eine Anordnung zur optischen Messung einer elektrischen Spannung mittels eines elektrooptischen Kristalls (Pockels-Kristalls) offenbart, bei der eine Temperaturkompensation über die Temperaturabhängigkeit der Dielektrizitätskonstante des elektrooptischen Kristalls durchgeführt wird. Dazu wird zunächst der kapazitive elektrische Strom, der durch den elektrooptischen Kristall fließt, erfaßt und über eine elektrische Schaltung in optische Pulse umgesetzt, die dem zeitlichen Mittelwert des Stromes durch den elektrooptischen Kristall entsprechen. Die Erfassung des Temperaturkorrekturwertes erfolgt hierbei somit zunächst über eine elektrische Hilfsgröße, die erst in einem zweiten Schritt in ein optisches Signal gewandelt wird.

Aus der Offenlegungsschrift DE 43 04 762 ist eine Anordnung zur optischen Erfassung eines elektrischen Stromes bekannt, die sich im Sensorkopf verdrillter niedrigdoppelbrechender optischer Fasern bedient. Das optische Signal aus dem Sensorkopf, das die Meßinformation in Form einer Faradayrotation trägt, wird polarimetrisch ausgewertet. Dazu wird das aus dem Sensorkopf austretende Licht über eine polarisationserhaltende Faser zu einer entfernten Detektions- und Auswerteeinheit übertragen, wo es in zwei Teillichtsignale mit zueinander senkrechter Polarisation zerlegt wird, die ihrerseits über Photodetektoren in entsprechende elektrische Signale S1 und S2 gewandelt werden. Aus dem Quotienten dieser beiden Signale S1 und S2 wird ein Temperatursignal abgeleitet und daraus die Temperatur des Sensorkopfes bestimmt. Damit kann ein Meßwert für den elektrischen Strom angegeben werden, der die Temperaturabhängigkeit des Sensorkopfes berücksichtigt.

Der Erfindung liegt nun die Aufgabe zugrunde, ein Verfahren und eine Vorrichtung zum Messen einer elektrischen Wechselgröße anzugeben, bei denen Einflüsse von Temperaturänderungen und von Intensitätsschwankungen auf das Meßsignal weitgehend kompensiert werden.

Diese Aufgabe wird gemäß der Erfindung gelöst mit den Merkmalen des Anspruchs 1 bzw. des Anspruchs 6. In eine unter dem Einfluß der elektrischen Wechselgröße stehende optische Sensoreinrichtung wird von Einkoppelmitteln polarisiertes Meßlicht eingekoppelt. Beim Durchlaufen der Sensoreinrichtung wird die Polarisation des Meßlichts in Abhängigkeit von der elektrischen Wechselgröße geändert. Nach wenigstens einmaligem Durchlaufen der Sensoreinrichtung wird das Meßlicht von einem Analysator in zwei linear polarisierte Lichtteilsignale mit unterschiedlichen Polarisationsebenen aufgeteilt. Anschließend werden diese beiden Lichtteilsignale von optoelektrischen Wandlern jeweils in entsprechende elektrische Intensitätssignale umgewandelt. Jedes dieser beiden Intensitätssignale wird gesondert intensitätsnormiert, indem von Normierungsmitteln das Quotientensignal aus seinem zugehörigen Wechselsignalanteil und seinem zugehörigen Gleichsignalanteil gebildet wird. Dadurch können Intensitätsschwankungen der optischen Einkoppelmittel und in den Übertragungsstrecken für die beiden Lichtteilsignale kompensiert werden. Aus den beiden Quotientensignalen als intensitätsnormierten Signalen S1 und S2 wird nun von Auswertemitteln ein von der Temperatur T im System weitgehend unabhängiges Meßsignal M für die elektrische Wechselgröße abgeleitet gemäß den beiden Gleichungen

$$S1 = f1(T) * M \tag{1}$$

$$S2 = f2(T) * M \tag{2},$$

in denen f1(T) und f2(T) vorgegebene Fit-Funktionen der Temperatur T sind.

Die Fit-Funktionen f1(T) und f2(T) stellen theoretische Näherungen (Fitting) für die Temperaturabhängigkeiten der beiden intensitätsnormierten Signale S1 und S2 dar und können insbesondere Polynome vom Grad n mit $n \geq 1$ oder auch exponentielle Funktionen der Temperatur T sein. Der Aufwand von Eichmessungen kann durch dieses Fitting deutlich reduziert werden.

Messungen haben ergeben, daß auch die einfachsten Polynome für n=1 (lineare Funktionen f1(T) und f2(T)) oder n=2 (quadratische Funktionen f1(T) und f2(T)) in Verbindung mit den Gleichungen (1) und (2) für die Temperaturabhängigkeiten der beiden intensitätsnormierten Signale S1 und S2 eine ausgezeichnete Näherung darstellen.

Im Falle linearer Fit-Funktionen

$$f1(T) = a0 + a1 \cdot T \tag{3}$$

$$f2(T) = b0 + b1 \cdot T \tag{4}$$

mit den reellen Koeffizienten a0, a1, b0 und b1 ergibt sich durch Einsetzen der Gleichungen (3) und (4) in die Gleichungen (1) und (2) und Auflösen nach M ein linear von den beiden intensitätsnormierten Signalen S1 und S2 abhängendes Meßsignal

$$M = A * S1 + B * S2 \tag{5}$$

mit den Koeffizienten

$$A = b1/(a0 \cdot b1 - a1 \cdot b0)$$

$$B = - a1/(a0 \cdot b1 - a1 \cdot b0).$$

Im Falle quadratischer Fit-Funktionen

$$f1(T) = c0 + c1 \cdot T + c2 \cdot T^2 \tag{6}$$

$$f2(T) = d0 + d1 \cdot T + d2 \cdot T^2 \tag{7}$$

der Temperatur T ergibt sich durch Einsetzen der Gleichungen (6) und (7) in die Gleichungen (1) und (2) und Auflösen nach M der Ausdruck

$$M = (1/G) * (A' * S1 + B' * S2 \pm C * (D * S1^2 + E * S1 * S2 + F * S2^2)^{1/2}) \tag{8}$$

für das Meßsignal M. Die reellen Koeffizienten A', B', C, D, E, F und G in der Gleichung (8) sind dabei mit den Koeffizienten c0, c1, c2 und d0, d1, d2 in den Gleichungen (6) und (7) in folgender Weise eindeutig verknüpft:

$$A' = c2 \cdot d1^2 - 2 \cdot c2 \cdot d0 \cdot d2 - c1 \cdot d1 \cdot d2 + 2 \cdot c0 \cdot d2^2$$

$$B' = 2 \cdot c2^2 \cdot d0 - c1 \cdot c2 \cdot d1 + c1^2 \cdot d2 - 2 \cdot c0 \cdot c2 \cdot d2$$

$$C = c2 \cdot d1 - c1 \cdot d2$$

$$D = d1^2 - 4 \cdot d0 \cdot d2$$

$$E = 4 \cdot c2 \cdot d0 - 2 \cdot c1 \cdot d1 + 4 \cdot c0 \cdot d2$$

$$F = c1^2 - 4 \cdot c0 \cdot c2$$

$$G = 1/(2 \cdot (c2^2 \cdot d0 - c1 \cdot c2 \cdot d0 \cdot d1 + c0 \cdot c2 \cdot d1^2 + c1^2 \cdot d0 \cdot d2 - 2 \cdot c0 \cdot c2 \cdot d0 \cdot d2 - c0 \cdot c1 \cdot d1 \cdot d2 + a0^2 \cdot b2^2))$$

Das Vorzeichen vor dem Quadratwurzelausdruck $C * (D * S1^2 + E * S1 * S2 + F * S2^2)^{1/2}$ in Gleichung (8) ergibt sich aus dem physikalisch-technischen Zusammenhang und ist insbesondere abhängig von dem Temperaturbereich für die Temperatur T, in dem das Meßsignal M kompensiert werden soll.

Wählt man dagegen exponentielle Fit-Funktionen

$$f1(T) = g1 \cdot exp(h1 \cdot T) \tag{9}$$

$$f2(T) = g2 \cdot exp(h2 \cdot T) \tag{10}$$

mit der Exponentialfunktion exp und den reellen Koeffizienten g1, g2, h1 und h2, so ergibt sich das Meßsignal M aus den beiden intensitätsnormierten Signalen S1 und S2 gemäß

$$M = ((1/g1) * S1)^{\gamma+1} * ((1/g2) * S2)^{-\gamma} \tag{11},$$

wobei der Koeffizient $\gamma$ in den beiden Exponenten mit den Koeffizienten h1 und h2 in den Gleichungen (9) und (10) gemäß

$$\gamma = h1/(h2-h1)$$

in Beziehung steht.

In der Notation bedeuten "$*$" eine Multiplikation von Signalen und "$\cdot$" eine Multiplikation von reellen Zahlen.

Weitere vorteilhafte Ausgestaltungen des Meßverfahrens und der Meßvorrichtung gemäß der Erfindung ergeben sich aus den jeweils abhängigen Ansprüchen.

Zur weiteren Erläuterung der Erfindung wird auf die Zeichnung Bezug genommen, in deren

FIG. 1    ein prinzipieller Aufbau einer Vorrichtung zum Messen einer elektrischen Wechselgröße,

FIG. 2    eine Ausführungsform der Normierungsmittel für eine solche Meßvorrichtung,

FIG. 3    ein Teil einer Ausführungsform einer Vorrichtung zum Messen eines elektrischen Wechselstromes und,

FIG. 4    ein Teil einer Ausführungsform einer Vorrichtung zum Messen einer elektrischen Wechselspannung

schematisch veranschaulicht sind. Einander entsprechende Teile sind mit denselben Bezugszeichen versehen.

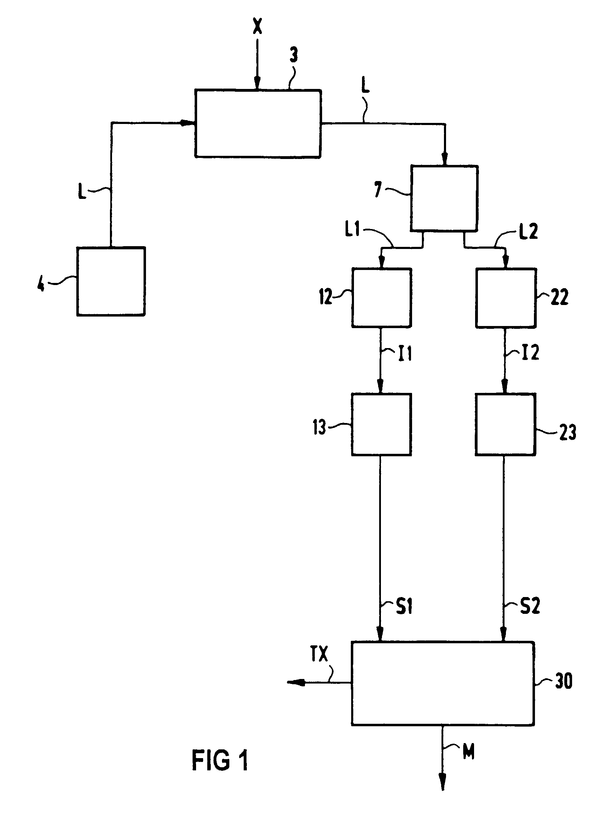

FIG. 1 zeigt eine Ausführungsform der Meßvorrichtung zum Messen einer elektrischen Wechselgröße X in einem prinzipiellen Aufbau. Es ist eine Sensoreinrichtung 3 vorgesehen, die unter dem Einfluß der elektrischen Wechselgröße X die Polarisation von in die Sensoreinrichtung 3 eingestrahltem polarisierten Meßlicht L in Abhängigkeit von der elektrischen Wechselgröße X ändert. Die Sensoreinrichtung 3 kann eine Faraday-Sensoreinrichtung zum Messen eines elektrischen Wechselstromes oder eines magnetischen Wechselfeldes unter Ausnutzung des magnetooptischen Faraday-Effekts oder auch eine Pockels-Sensoreinrichtung zum Messen einer elektrischen Wechselspannung oder eines elektrischen Wechselfeldes unter Ausnutzung des elektrooptischen Pockels-Effekts sein. In die Sensoreinrichtung 3 wird polarisiertes Meßlicht L eingekoppelt. Zum Erzeugen dieses polarisierten Meßlichts L können eine Lichtquelle 4 und zugeordnete, nicht dargestellte polarisierende Mittel oder auch eine selbst polarisierende Lichtquelle 4, beispielsweise eine Laserdiode, und gegebenenfalls zusätzliche, nicht dargestellte polarisierende Mittel vorgesehen sein. Das polarisierte Meßlicht L durchläuft die Sensoreinrichtung 3 wenigstens einmal und erfährt dabei eine von der elektrischen Wechselgröße X abhängige Änderung seiner Polarisation. Nach dem Durchlaufen der Sensoreinrichtung 3 wird das Meßlicht L einem Analysator 7 zugeführt und im Analysator 7 in zwei linear polarisierte Lichtteilsignale L1 und L2 zerlegt, deren Polarisationsebenen verschieden voneinander sind. Vorzugsweise sind die Polarisationsebenen der beiden Lichtteilsignale L1 und L2 senkrecht zueinander gerichtet (orthogonale Zerlegung). Als Analysator 7 können ein polarisierender Strahlteiler, beispielsweise ein Wollaston-Prisma, oder auch ein einfacher Strahlteiler mit einem teildurchlässigen Spiegel und zwei nachgeschaltete, um einen entsprechenden Winkel und vorzugsweise um 90° gekreuzte Polarisationsfilter vorgesehen sein. Die Sensoreinrichtung 3 und der Analysator 7 können über eine Freistrahlanordnung oder auch über einen polarisationserhaltenden Lichtleiter, vorzugsweise eine Monomode-Lichtfaser wie beispielsweise eine HiBi(High Birefringence)-Faser oder eine polarisationsneutrale LoBi(Low Birefringence)-Faser, optisch miteinander verbunden sein.

Die beiden Lichtteilsignale L1 und L2 werden dann jeweils einem photoelektrischen Wandler 12 bzw. 22 zugeführt. Die Übertragung der beiden Lichtteilsignale L1 und L2 vom Analysator 7 zu dem jeweils zugehörigen Wandler 12 bzw. 22 kann über eine Freistrahlanordnung oder über jeweils einen Lichtleiter erfolgen. In den Wandlern 12 und 22 werden die beiden Lichtteilsignale L1 und L2 jeweils in ein elektrisches Intensitätssignal I1 bzw. I2 umgewandelt, das ein Maß für die Intensität des zugehörigen Lichtteilsignals L1 bzw. L2 ist.

Die beiden elektrischen Intensitätssignale I1 und I2 werden jeweils einem Eingang von zugeordneten Normierungsmitteln 13 bzw. 23 zugeführt. Die Normierungsmittel 13 und 23 bilden aus dem zugehörigen Intensitätssignal I1 bzw. I2 jeweils ein intensitätsnormiertes Signal S1 bzw. S2, das dem Quotienten $S1 = A1/D1$ (oder $S1 = D1/A1$) bzw. $S2 = A2/D2$ (oder $S2 = D2/A2$) aus einem Wechselsignalanteil AI bzw. A2 und einem Gleichsignalanteil D1 bzw. D2 des zugehörigen Intensitätssignals I1 bzw. I2 entspricht. Die beiden intensitätsnormierten Signale S1 und S2 sind im wesentlichen unabhängig von Intensitätsänderungen der Lichtquelle 4 und in den optischen Übertragungsstrecken für das Meßlicht L und die beiden Lichtteilsignale L1 und L2. Auch unterschiedliche Intensitätsänderungen in den beiden optischen Übertragungsstrecken für die Lichtteilsignale L1 und L2 werden durch diese Intensitätsnormierung kompensiert. Deshalb können als Übertragungsstrecken für die beiden Lichtteilsignale L1 und L2 auch jeweils eine Multimode-Faser vorgesehen sein.

Ein Problem bereiten nun jedoch Änderungen der Temperatur, die eine Verschiebung des Arbeitspunktes und eine Änderung der Meßempfindlichkeit der Meßvorrichtung zur Folge haben können. Diese temperaturinduzierten Meßfehler werden nun durch ein im folgenden beschriebenes Temperaturkompensationsverfahren im wesentlichen beseitigt.

Zur Temperaturkompensation werden die beiden intensitätsnormierten Signale S1 und S2 Auswertemitteln 30 zugeführt. Die Auswertemittel 30 leiten aus den beiden intensitätsnormierten Signalen S1 und S2 ein weitgehend temperaturunabhängiges Meßsignal M für die elektrische Wechselgröße X als Funktion M(S1, S2) der beiden intensitätsnormierten Signale S1 und S2 ab, das an einem Ausgang der Auswertemittel 30 abgegriffen werden kann. Die zugrunde liegende Funktion M(S1, S2) ist durch die beiden bereits genannten Gleichungen

$$S1 = f1(T) * M \tag{1}$$

und

$$S2 = f2(T) * M \tag{2}$$

festgelegt. Diese Gleichungen beruhen auf der Annahme, daß sich die beiden intensitätsnormierten Signale S1 und S2 jeweils als Produkt aus einer Funktion f1(T) bzw. f2(T) der Temperatur und einem temperaturunabhängigen Signal M darstellen lassen (Faktorisierung). Die beiden die Temperaturabhängigkeit charakterisierenden Funktionen f1(T) und f2(T) sind dabei vorbestimmte Fit-Funktionen über einem vorgegebenen Temperaturintervall für die Temperatur T im optischen System und so gewählt, daß die Gleichungen (1) und (2) in diesem Temperaturintervall in physikalisch eindeutiger Weise nach dem Meßsignal M aufgelöst werden können.

Als Fit-Funktionen f1(T) und f2(T) können in einer Ausführungsform Polynome n-ter Ordnung mit der natürlichen Zahl n, vorzugsweise lineare oder quadratische Funktionen f1(T) und f2(T) gemäß den Gleichungen (3) und (4) bzw. (6) und (7), verwendet werden. Es hat sich gezeigt, daß auch mit den vergleichsweise einfachen linearen und quadratischen Interpolationsfunktionen f1(T) und f2(T) gemäß den Gleichungen (3) und (4) bzw. (6) und (7) eine gute Annäherung an die gemessene Temperaturabhängigkeit erreicht wird. Im Fall linearer Funktionen f1(T) und f2(T) wird das Meßsignal M = M(S1, S2) gemäß der bereits genannten Gleichung

$$M = A * S1 + B * S2 \tag{5}$$

mit den reellen Koeffizienten A und B, im Falle quadratischer Funktionen f1(T) und f2(T) dagegen gemäß der zuvor beschriebenen Gleichung

$$M = (1/G)*(A'*S1 + B'*S2 \pm C*(D*S1^2+E*S1*S2+F*S2^2)^{1/2}) \tag{8}$$

mit den reellen Koeffizienten A', B', C, D, E, F und G ermittelt. Bei Polynomen höheren Grades n als 2 für die Funktionen f1(T) und f2(T) ergeben sich entsprechend kompliziertere Ausdrücke für das Meßsignal M.

In einer anderen Ausführungsform mit exponentiellen Fit-Funktionen f1(T) und f2(T) gemäß den Gleichungen (9) und (10) wird das Meßsignal M von den Auswertemitteln 30 aus den beiden intensitätsnormierten Signalen S1 und S2 gemäß

$$M = ((1/g1)*S1)^{\gamma+1} * ((1/g2)*S2)^{-\gamma} \tag{11}$$

abgeleitet mit den bereits definierten reellen Koeffizienten g1, g2 und $\gamma$.

Zum Ermitteln des Meßsignals M, insbesondere gemäß den Gleichungen (5), (8) oder (11) können die Auswertemittel 30 einen Analog/Digital-Wandler zum Digitalisieren der beiden intensitätsnormierten Signale S1 und S2 und einen digitalen Signalprozessor (DSP) oder einen Mikroprozessor zum digitalen Berechnen des Meßsignals M aus den digitalisierten Signalen S1 und S2 enthalten. Insbesondere für die vergleichsweise einfache Berechnung des Meßsignals M als lineare Funktion der beiden intensitätsnormierten Signale S1 und S2 gemäß Gleichung (5) können die Auswertemittel 30 aber auch analoge arithmetische Bauelemente enthalten. Die Produkte A*S1 und B*S2 können mit Hilfe von Verstärkern gebildet werden, die das an ihrem jeweiligen Eingang angelegte Signal S1 bzw. S2 mit dem auf den Koeffizienten A bzw. B eingestellten Verstärkungsfaktor verstärken. Die Summe der beiden Produkte A*S1 und B*S2 wird dann von einem Addierer gebildet und kann als Meßsignal M ausgegeben werden. Mit analogen Bauelementen kann die Temperaturkompensation besonders schnell durchgeführt werden. Außerdem können die Auswertemittel 30 auch wenigstens einen, nicht dargestellten, vorab ermittelten Wertespeicher enthalten, mit dem einem Wertepaar (S1, S2) der beiden intensitätsnormierten Signale S1 und S2 ein zugehöriges temperaturkompensiertes Meßsignal M als Funktion M(S1, S2) der beiden intensitätsnormierten Signale S1 und S2 zugeordnet wird. Der Wertespeicher kann eine entsprechende Wertetabelle oder auch eine entsprechende Eichfunktion enthalten.

In einer vorteilhaften Ausführungsform leiten die Auswertemittel 30 aus den beiden intensitätsnormierten Signalen S1 und S2 außer dem Meßsignal M für die elektrische Wechselgröße X auch einen Temperaturmeßwert TX für die Temperatur T mit Hilfe der zwei Gleichungen (1) und (2) und der jeweils vorgegebenen Fit-Funktionen f1(T) und f2(T) ab. Dieser Temperaturmeßwert TX steht dann an einem Ausgang der Auswertemittel 30 an.

Bei linearen Fit-Funktionen f1(T) und f2(T) gemäß den Gleichungen (3) und (4) ergibt sich beispielsweise mit den Gleichungen (1) und (2) ein Temperaturmeßwert

$$TX = (b0*S1-a0*S2)/(a1*S1+b1*S2) \tag{12}.$$

Bei exponentiellen Fit-Funktionen f1(T) und f2(T) gemäß den Gleichungen (9) und (10) berechnet sich der Tem-

peraturmeßwert TX gemäß

$$TX = (1/(h1\text{-}h2)) * \ln((g2*S1)/(g1*S2)) \qquad (13)$$

mit der natürlichen Logarithmusfunktion ln.

Das Meßsignal M ist mit dem Temperaturmeßwert TX über die Beziehungen

$$M = S1/f1(TX) = S2/f2(TX) \qquad (14)$$

verknüpft. Das Meßsignal M kann deshalb auch hergeleitet werden, indem zunächst ein Temperaturmeßwert TX aus den Gleichungen (1) und (2) mit vorgegebenen Funktionen f1(T) und f2(T) abgeleitet wird und dann aus einem der beiden intensitätsnormierten Signale S1 oder S2 und dem zugehörigen Funktionswert f1(TX) bzw. f2(TX) gemäß Gleichung (14) das Meßsignal M ermittelt wird.

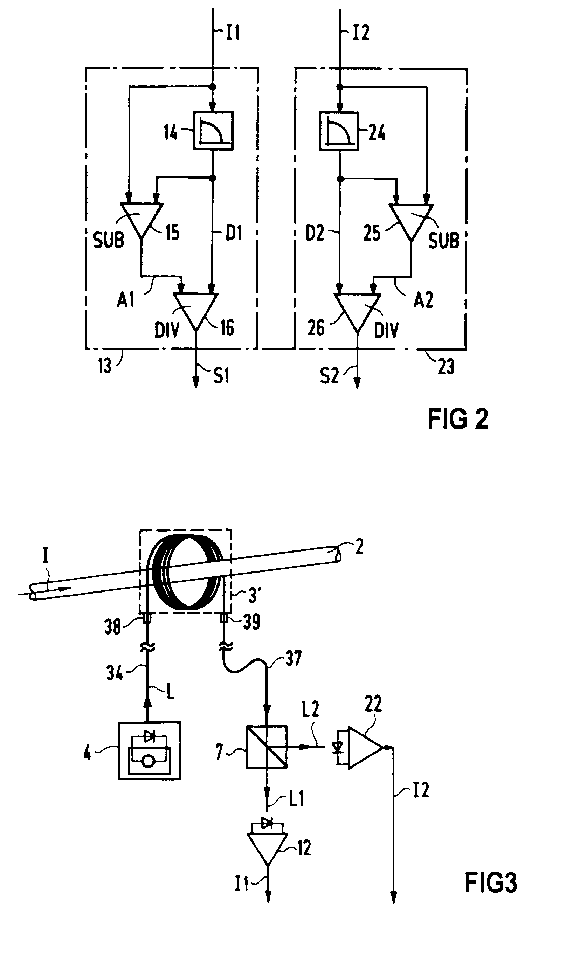

FIG. 2 zeigt eine vorteilhafte Ausführungsform der Normierungsmittel 13 und 23. Die ersten Normierungsmittel 13 enthalten ein mit dem optoelektrischen Wandler 12 elektrisch verbundenes Tiefpaßfilter 14, einen Subtrahierer (SUB) 15 und einen Dividierer (DIV) 16. Die zweiten Normierungsmittel 23 enthalten ein mit dem zweiten optoelektrischen Wandler 22 elektrisch verbundenes Tiefpaßfilter 24, einen Subtrahierer (SUB) 25 und einen Dividierer (DIV) 26. Jedes Tiefpaßfilter 14 und 24 läßt vom an seinem Eingang anliegenden Intensitätssignal I1 bzw. I2 nur einen Gleichsignalanteil D1 bzw. D2 passieren. Jeder Gleichsignalanteil D1 und D2 des zugehörigen Intensitätssignals I1 bzw. I2 entspricht dabei den Frequenzanteilen des Intensitätssignals I1 bzw. I2, die unterhalb einer vorgegebenen Trennfrequenz des zugeordneten Tiefpaßfilters 14 bzw. 24 liegen. An die jeweils zwei Eingänge der Subtrahierer 15 und 25 werden zum einen das zugehörige Intensitätssignal I1 bzw. I2 und zum anderen der Gleichsignalanteil D1 bzw. D2 dieses Intensitätssignals I1 bzw. I2 angelegt. Die Subtrahierer 15 und 25 bilden jeweils einen Wechselsignalanteil AI bzw. A2 des zugehörigen Intensitätssignals I1 bzw. I2 durch Subtraktion des Gleichsignalanteils D1 bzw. D2 vom gesamten Intensitätssignal I1 bzw. I2. Die Trennfrequenzen beider Tiefpaßfilter 14 und 24 sind dabei so hoch gewählt, daß die Wechselsignalanteile A1 und A2 der Intensitätssignale I1 und I2 im wesentlichen alle Informationen über die zu messende Wechselgröße X, also insbesondere das gesamte Frequenzspektrum der elektrischen Wechselgröße X, enthalten. Insbesondere ist die Trennfrequenz kleiner als eine Grundfrequenz der Wechselgröße X zu wählen. Tiefpaßfilter 14 oder 24 und Subtrahierer 15 bzw. 25 bilden somit Mittel zum Zerlegen des ersten Intensitätssignals I1 bzw. zweiten Intensitätssignals I2 in einen Wechselsignalanteil A1 bzw. A2 und einen Gleichsignalanteil D1 bzw. D2.

Anstelle der in FIG. 2 gezeigten Ausführungsformen dieser Mittel zum Zerlegen können natürlich auch Hochpaßfilter und Tiefpaßfilter zum Herausfiltern der Wechselsignalanteile A1 und A2 bzw. der Gleichsignalanteile D1 und D2 vorgesehen sein oder auch jeweils ein Hochpaßfilter zum Herausfiltern des Wechselsignalanteils A1 oder A2 und ein Subtrahierer zum Ableiten des Gleichsignalanteils D1=I1-A1 bzw. D2=I2-A2. Ferner können auch Mischformen dieser Ausführungsformen verwendet werden.

Der Wechselsignalanteil A1 und der Gleichsignalanteil D1 des ersten Intensitätssignals I1 werden nun jeweils einem Eingang des Dividierers 16 zugeführt. An einem Ausgang des Dividierers 16 steht dann das erste intensitätsnormierte Signal S1 = A1/D1 als Quotient aus Wechselsignalanteil A1 und Gleichsignalanteil D1 des ersten Intensitätssignals I1 an. Ebenso werden der Wechselsignalanteil A2 und der Gleichsignalanteil D2 des zweiten Intensitätssignals I2 dem zweiten Dividierer 26 zugeführt, der das intensitätsnormierte Signal S2 = A2/D2 für das zweite Intensitätssignal I2 bildet. Die beiden intensitäsnormierten Signale S1 und S2 können dann an entsprechenden Ausgängen der Normierungsmittel 13 bzw. 23 abgegriffen werden.

In der FIG. 3 ist ein Teil einer Meßvorrichtung zum Messen eines elektrischen Wechselstromes I in einem Stromleiter 2 mit wenigstens einem dem Stromleiter 2 zugeordneten Faraday-Element 3' als Sensoreinrichtung dargestellt. Linear polarisiertes Meßlicht L einer linear polarisierten Lichtquelle 4, beispielsweise einer Laserdiode, wird über einen vorzugweise polarisationserhaltenden Lichtleiter 34 in das Faraday-Element 3' eingekoppelt, nach wenigstens einem Durchlauf durch das Faraday-Element 3' aus dem Faraday-Element 3' wieder ausgekoppelt und über einen vorzugsweise polarisationserhaltenden Lichtleiter 37 dem Analysator 7 zugeführt. Die Übertragung des ausgekoppelten Meßlichts vom Faraday-Element 3' zum Analysator 7 kann aber auch über eine Freistrahlanordnung erfolgen. Das ausgekoppelte Meßlicht weist eine aufgrund des Faraday-Effekts um einen nicht dargestellten Meßwinkel $\alpha$ gedrehte Polarisation auf. Der Meßwinkel $\alpha$ ist dabei abhängig von einem elektrischen Wechselstrom I in dem Stromleiter 2.

In der dargestellten Ausführungsform gemäß FIG. 3 ist das Faraday-Element 3' mit einem Lichtleiter, vorzugsweise einer optischen Faser, gebildet, der den Stromleiter 2 in einer Meßwicklung mit wenigstens einer Meßwindung umgibt. Der Lichtleiter des Faraday-Elements 3' ist mit dem Lichtleiter 34 zum Zuführen des Meßlichts L und mit dem Lichtleiter 37 zum Abführen des Meßlichts L vorzugsweise jeweils über einen Spleiß 38 bzw. 39 verbunden. Als Faraday-Element 3' können jedoch auch ein oder mehrere massive Körper aus einem Faraday-Material, der bzw. die einen vorzugsweise den Stromleiter 2 umgebenden Lichtpfad für das Meßlicht bilden, vorgesehen sein, vorzugsweise ein Glasring. Das Faraday-Element 3' muß den Stromleiter 2 nicht in einem geschlossenen Lichtpfad umgeben, sondern kann auch nur in räumliche Nähe neben dem Stromleiter 2 angeordnet sein. Außerdem ist neben der dargestellten Ausführungsform vom Transmissionstyp, bei der das Meßlicht das Faraday-Element 3' nur in einer Richtung durchläuft, auch eine Ausführungsform vom Reflexionstyp möglich, bei der das Meßlicht L nach einem ersten Durchlauf in das Faraday-Element 3' zurückreflektiert wird und das Faraday-Element 3' ein zweites Mal in umgekehrter Richtung durchläuft.

Das aus dem Faraday-Element 3' ausgekoppelte Licht wird von dem Analysator 7 in zwei linear polarisierte Lichtsignale L1 und L2 mit verschiedenen und vorzugsweise senkrecht zueinander gerichteten Polarisationsebenen aufgespalten. Dazu ist als Analysator 7 vorzugsweise ein polarisierender Strahlteiler wie beispielsweise ein Wollaston-Prisma vorgesehen. Es können für diese Funktion allerdings auch zwei um einen entsprechenden Winkel und vorzugsweise um 90° gekreuzte Polfilter und ein einfacher Strahlteiler vorgesehen sein.

Die beiden Lichtsignale L1 und L2 werden dann in zugeordneten optoelektrischen Wandlern 12 bzw. 22, für die vorzugsweise in Verstärkerkreise geschaltete Photodioden vorgesehen sind, in elektrische Intensitätssignale I1 bzw. I2 umgewandelt, die ein Maß für die Lichtintensitäten der jeweiligen Lichtsignale L1 und L2 sind.

Das Meßverfahren und die Meßvorrichtung gemäß FIG. 3 können natürlich auch direkt zum Messen von magnetischen Wechselfeldern verwendet werden, indem das Faraday-Element 3' in dem magnetischen Wechselfeld angeordnet wird.

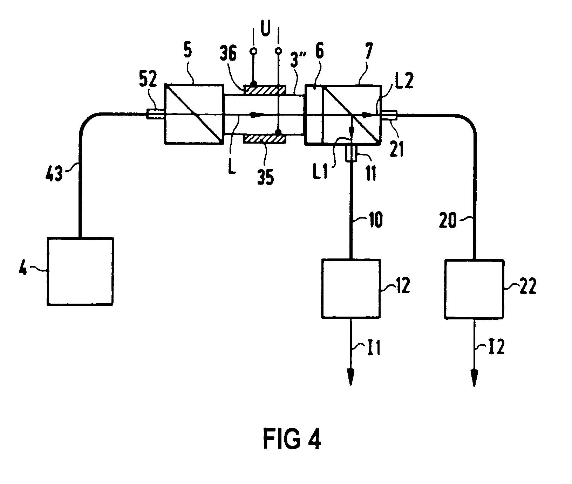

FIG. 4 zeigt eine Ausführungsform eines Teils einer Vorrichtung zum Messen einer elektrischen Wechselspannung U als Wechselgröße X mit einem Pockels-Element 3" als Teil einer Pockels-Sensoreinrichtung. Die zu messende Wechselspannung U ist über zwei Elektroden 35 und 36 an das Pockels-Element 3" anlegbar. In das Pockels-Element 3" wird polarisiertes Meßlicht L eingekoppelt. Dieses Meßlicht L durchläuft das Pockels-Element 3" und erfährt dabei eine von der angelegten Wechselspannung U abhängige Änderung seiner Polarisation. Die Wechselspannung U wird in der dargestellten Ausführungsform senkrecht zur Lichtausbreitungsrichtung des Meßlichts L angelegt (transversale Ausführungsform), kann aber auch parallel zur Lichtausbreitungsrichtung angelegt werden (longitudinale Ausführungsform). Als Mittel zum Einkoppeln des Meßlichtes L in das Pockels-Element 3" sind eine Lichtquelle 4, beispielsweise eine Leuchtdiode, und ein Polarisator 5 zum linearen Polarisieren des Lichts der Lichtquelle 4 vorgesehen. Die Lichtquelle 4 und der Polarisator 5 sind vorzugsweise über einen Lichtleiter 43, beispielsweise eine Multimode-Lichtfaser, optisch miteinander verbunden, können aber auch durch eine Freistrahlkopplung optisch miteinander gekoppelt sein. Zum Koppeln des Lichts aus dem Lichtleiter 43 in den Polarisator 5 ist vorzugsweise eine Kollimatorlinse (Grin lens) 52 vorgesehen. Aus dem Polarisator 5 wird das nun linear polarisierte Meßlicht L in das Pockels-Element 3" eingekoppelt. Nach Durchlaufen des Pockels-Elements 3 wird das Meßlicht L über ein $\lambda/4$-Plättchen 6 dem Analysator 7 zugeführt. In dem Analysator 7 wird das Meßlicht L in zwei linear polarisierte Lichtteilsignale L1 und L2 zerlegt, deren Polarisationsebenen verschieden voneinander sind. Vorzugsweise sind die Polarisationsebenen der beiden Lichtteilsignale L1 und L2 senkrecht zueinander gerichtet (orthogonale Zerlegung). Als Analysator 7 können ein polarisierender Strahlteiler, beispielsweise ein Wollaston-Prisma, oder auch zwei um einen vorgegebenen Winkel, vorzugsweise 90°, gekreuzte Polarisationsfilter und ein einfacher Strahlteiler vorgesehen sein.

Die beiden Lichtteilsignale L1 und L2 werden vorzugsweise über jeweils eine Kollimatorlinse 11 bzw. 21 in jeweils einen Lichtleiter 10 bzw. 20 eingekoppelt und über diesen Lichtleiter 10 bzw. 20, beispielsweise jeweils eine Multimode-Lichtfaser, jeweils dem zugehörigen photoelektrischen Wandler 12 bzw. 22 zugeführt. In den Wandlern 12 und 22 werden die beiden Lichtteilsignale L1 und L2 jeweils in ein elektrisches Intensitätssignal I1 bzw. I2 umgewandelt, das ein Maß für die Intensität des zugehörigen Lichtteilsignals L1 bzw. L2 ist.

Der Arbeitspunkt der Meßvorrichtung wird vorzugsweise so eingestellt, daß am Analysator 7 zirkular polarisiertes Meßlicht anliegt, wenn am Pockels-Element 3" keine elektrische Spannung oder kein elektrisches Feld anliegt. Die beiden Eigenachsen der linearen Doppelbrechung im Pockels-Element 3" sind in diesem Fall vom Meßlicht L "gleichmäßig ausgeleuchtet". Das bedeutet, daß die auf die beiden Eigenachsen projizierten Komponenten des Meßlichts L jeweils die gleiche Intensität aufweisen. Im allgemeinen sind dann die beiden Lichtteilsignale L1 und L2 gleich stark in ihrer Intensität. Bei Anlegen einer Wechselspannung $U \neq 0\,V$ an das Pockels-Element 3" werden die Komponenten des Meßlichts L entlang der elektrooptisch aktiven Eigenachsen der linearen Doppelbrechung des Pockels-Elements 3" in ihrer Intensität in Abhängigkeit von der Wechselspannung U geändert.

Eine solche Änderung der Polarisation des Meßlichts L wird jedoch auch verursacht durch eine Änderung der Temperatur im Pockels-Element 3" oder auch dem $\lambda/4$-Plättchen 6 und einer damit bewirkten temperaturabhängigen linearen Doppelbrechung. Temperaturänderungen führen somit zu einer Verschiebung des Arbeitspunktes der Meßvorrichtung. Diese temperaturabhängige Arbeitspunktdrift wird nun durch das bereits beschriebene Temperaturkompensationsverfahren mit Hilfe der in FIG. 4 nicht dargestellten Normierungsmittel 13 und 23 sowie der Auswertemittel 30 weitgehend kompensiert.

Anstelle der in FIG. 4 dargestellten optischen Reihenschaltung des Polarisators 5, des Pockels-Elements 3", des $\lambda/4$-Plättchens 6 und des Analysators 7 kann auch eine optische Reihenschaltung aus dem Polarisator 5, dem $\lambda/4$-Plättchen 6, dem Pockels-Element 3" und dem Analysator 7 vorgesehen sein, also die Reihenfolge des $\lambda/4$-Plätt-

chens 6 und des Pockels-Elements 3" gerade vertauscht sein. In diesem Fall wird das Meßlicht L vor dem Einkoppeln in das Pockels-Element 3" zirkular polarisiert.

Außerdem kann anstelle der Lichtquelle 4 und des Polarisators 5 auch eine Lichtquelle zum Senden linear polarisierten Lichts wie beispielsweise eine Laserdiode vorgesehen sein zum Einkoppeln von polarisiertem Meßlicht L in das Pockels-Element 3" bzw. das λ/4-Plättchen 6. Der Lichtleiter 43 ist dann vorzugsweise ein polarisationserhaltender Lichtleiter.

Die Übertragung der Lichtteilsignale L1 bzw. L2 kann ferner auch in einer Freistrahlanordnung erfolgen. Der Analysator 7 kann überdies mit dem λ/4-Plättchen 6 bzw. dem Pockels-Element 3" über einen polarisationserhaltenden Lichtleiter optisch verbunden sein.

**Patentansprüche**

1. Verfahren zum Messen einer elektrischen Wechselgröße (X) mit folgenden Merkmalen:

a) es wird polarisiertes Meßlicht (L) in eine unter dem Einfluß der elektrischen Wechselgröße (X) stehende Sensoreinrichtung (3) eingekoppelt, die die Polarisation des sie durchlaufenden Meßlichts (L) in Abhängigkeit von der elektrischen Wechselgröße (X) ändert;
b) das Meßlicht (L) wird nach wenigstens einmaligem Durchlaufen der Sensoreinrichtung (3) von einem Analysator (7) in zwei linear polarisierte Lichtteilsignale (L1, L2) mit unterschiedlichen Polarisationsebenen aufgeteilt;
c) die beiden Lichtteilsignale (L1, L2) werden jeweils in ein elektrisches Intensitätssignal (I1, I2) umgewandelt;
d) für jedes dieser beiden elektrischen Intensitätssignale (I1, I2) wird ein intensitätsnormiertes Signal S1 bzw. S2 gebildet, das einem Quotienten (A1/D1, A2/D2) aus einem Wechselsignalanteil (A1, A2) und einem Gleichsignalanteil (D1, D2) des zugehörigen Intensitätssignals (I1, I2) entspricht;
e) aus den beiden intensitätsnormierten Signalen S1 und S2 wird nun ein von der Temperatur T weitgehend unabhängiges Meßsignal M für die elektrische Wechselgröße (X) gemäß den beiden Gleichungen

$$S1 = f1(T) * M \qquad (1)$$

$$S2 = f2(T) * M \qquad (2)$$

abgeleitet in denen f1(T) und f2(T) jeweils vorgegebene Fit-Funktionen der Temperatur T sind.

2. Verfahren nach Anspruch 1, bei dem die Fit-Funktionen f1(T) und f2(T) lineare Funktionen der Temperatur T sind.

3. Verfahren nach Anspruch 1, bei dem die Fit-Funktionen f1(T) und f2(T) quadratische Funktionen der Temperatur T sind.

4. Verfahren nach Anspruch 1, bei dem die Fit-Funktionen f1(T) und f2(T) Exponentialfunktionen der Temperatur T sind.

5. Verfahren nach einem der Ansprüche 1 bis 4, bei dem zusätzlich ein Temperaturmeßwert (TX) für die Temperatur T aus den beiden intensitätsnormierten Signalen S1 und S2 gemäß den genannten beiden Gleichungen (1) und (2) abgeleitet wird.

6. Vorrichtung zum Messen einer elektrischen Wechselgröße (X) mit

a) Mitteln (4, 34) zum Einkoppeln polarisierten Meßlichts (L) in eine unter dem Einfluß der Wechselgröße (X) stehende Sensoreinrichtung (3), die die Polarisation des durchlaufenden Meßlichts (L) in Abhängigkeit von der elektrischen Wechselgröße (X) ändert,
b) einem Analysator (7) zum Aufteilen des Meßlichts (L) nach wenigstens einmaligem Durchlaufen der Sensoreinrichtung (3) in zwei linear polarisierte Lichtteilsignale (L1, L2) mit unterschiedlichen Polarisationsebenen,
c) optoelektrischen Wandlern (12, 22) zum Umwandeln der beiden Lichtteilsignale (L1, L2) in jeweils ein elektrisches Intensitätssignal (I1, I2),
d) Normierungsmitteln (13, 23), die für beide Intensitätssignale (I1, I2) jeweils ein intensitätsnormiertes Signal

EP 0 786 091 B1

S1 bzw. S2 bilden, das einem Quotienten aus einem Wechselsignalanteil und einem Gleichsignalanteil des zugehörigen Intensitätssignal (I1, I2) entspricht;

e) Auswertemitteln (20) zum Ableiten eines von der Temperatur T weitgehend unabhängigen Meßsignals M für die elektrische Wechselgröße (X) aus den beiden intensitätsnormierten Signalen S1 und S2 gemäß den beiden Gleichungen

$$S1 = f1(T) * M \tag{1}$$

$$S2 = f2(T) * M \tag{2},$$

wobei f1(T) und f2(T) jeweils vorgegebene Funktionen der Temperatur T sind.

7. Vorrichtung nach Anspruch 6, bei der die Funktionen f1(T) und f2(T) lineare oder quadratische Funktionen der Temperatur T sind.

8. Vorrichtung nach Anspruch 6 oder Anspruch 7, bei der der Analysator (7) mit den optoelektrischen Wandlern (12, 22) über jeweils einen Lichtleiter (10, 20) für jedes Lichtteilsignal (L1, L2) optisch verbunden ist.

9. Vorrichtung nach Anspruch 8, bei der die Lichtleiter (10, 20) Multimode-Fasern sind.

10. Vorrichtung nach einem der Ansprüche 6 bis 9, bei der die Sensoreinrichtung (3) und der Analysator (7) über eine polarisationserhaltende Lichtleitfaser zum Übertragen des aus der Sensoreinrichtung (3) ausgekoppelten Meßlichts (L) optisch miteinander verbunden sind.


**Claims**

1. Method for measuring an electric alternating quantity (X), having the following features:

a) polarized measuring light (L) is coupled into a sensor device (3) which is under the influence of the electric alternating quantity (X) and changes the polarization of the measuring light (L) passing through it as a function of the electric alternating quantity (X);

b) after passing through the sensor device (3) at least once, the measuring light (L) is split by an analyser (7) into two linearly polarized light partial signals (L1, L2) having different planes of polarization;

c) the two light partial signals (L1, L2) are, in each case, converted into an electric intensity signal (I1, I2);

d) for each of these two electric intensity signals (I1, I2), an intensity-normalized signal S1 and S2 is formed, which corresponds to a quotient (A1/D1, A2/D2) of an AC signal component (A1, A2) and a DC signal component (D1, D2) of the associated intensity signal (I1, I2);

e) from the two intensity-normalized signals S1 and S2, a measured signal M, which is largely independent of the temperature T, for the electric alternating quantity (X) is now derived in accordance with the two equations

$$S1 = f1(T) * M \tag{1}$$

$$S2 = f2(T) * M \tag{2},$$

in which f1(T) and f2(T) are in each case predetermined fit-functions of the temperature T.

2. Method according to Claim 1, in which the fit-functions f1(T) and f2(T) are linear functions of the temperature T.

3. Method according to Claim 1, in which the fit-functions f1(T) and f2(T) are quadratic functions of the temperature T.

4. Method according to Claim 1, in which the fit-functions f1(T) and f2(T) are exponential functions of the temperature T.

5. Method according to one of Claims 1 to 4, in which in addition a temperature measured value (TX) for the temperature T is derived from the two intensity-normalized signals S1 and S2 in accordance with the said two equations (1) and (2).

6. Device for measuring an electric alternating quantity (X), having

a) means (4, 34) for coupling polarized measuring lights (L) into a sensor device (3) which is under the influence of the alternating quantity (X) and changes the polarization of the measuring light (L) passing through as a function of the electric alternating quantity (X),

b) an analyser (7) for splitting the measuring light (L), after passing through the sensor device (3) at least once, into two linearly polarized light partial signals (L1, L2) having different planes of polarization,

c) opto-electric converters (12, 22) for converting the two light partial signals (L1, L2) in each case into an electric intensity signal (I1, I2),

d) normalizing means (13, 23) which, for both intensity signals (I1, I2), in each case form an intensity-normalized signal S1 and S2, which corresponds to a quotient of an AC signal component and a DC signal component of the associated intensity signal (I1, I2);

e) evaluation means (20) for deriving a measured signal M, which is largely independent of the temperature T, for the electric alternating quantity (X) from the two intensity-normalized signals S1 and S2 in accordance with the two equations

$$S1 = f1(T) * M \tag{1}$$

$$S2 = f2(T) * M \tag{2},$$

where f1(T) and f2(T) are in each case predetermined functions of the temperature T.

7. Device according to Claim 6, in which the functions f1(T) and f2(T) are linear or quadratic functions of the temperature T.

8. Device according to Claim 6 or Claim 7, in which the analyser (7) is optically connected to the opto-electric converters (12, 22) via in each case an optical waveguide (10, 20) for each light partial signal (L1, L2).

9. Device according to Claim 8, in which the optical waveguides (10, 20) are multimode fibres.

10. Device according to one of Claims 6 to 9, in which the sensor device (3) and the analyser (7) are optically connected to each other via a polarization-maintaining optical fibre for transmitting the measuring light (L) coupled out of the sensor device (3).

**Revendications**

1. Procédé pour mesurer une grandeur (X) alternative électrique, comportant les dispositions suivantes :

a) on envoie de la lumière (L) de mesure polarisée dans un dispositif (3) capteur qui est soumis à l'influence de la grandeur (X) alternative électrique et qui, en fonction de la grandeur (X) alternative électrique, fait varier la polarisation de la lumière (L) de mesure qui y passe ;

b) après être passée au moins une fois dans le dispositif (3) capteur, la lumière (L) de mesure est séparée dans un analyseur (7) en deux signaux (L1, L2) lumineux partiels polarisés linéairement ayant des plans de polarisation différents ;

c) les deux signaux (L1, L2) lumineux partiels sont convertis chacun en un signal (I1, I2) d'intensité électrique ;

d) pour chacun de ces signaux (I1, I2) d'intensité électrique, il est formé un signal S1 et S2 normé en intensité qui correspond à un quotient (A1/D1, A2/D2) d'une composante (A1, A2) de signal alternatif et d'une composante (D1, D2) de signal continu du signal (I1, I2) d'intensité associé :

e) on déduit maintenant des deux signaux S1 et S2 normés en intensité un signal M de mesure de la grandeur (X) alternative électrique qui est dans une grande mesure indépendant de la température (T), suivant les deux équations

$$S1 = f1(T) * M \qquad (1)$$

$$S2 = f2(T) * M \qquad (2)$$

dans lesquelles f1(T) et f2(T) sont des fonctions Fit prescrites de la température (T).

2. Procédé suivant la revendication 1, dans lequel les fonctions f1(T) et f2(T) Fit sont des fonctions linéaires de la température (T).

3. Procédé suivant la revendication 1, dans lequel les fonctions f1(T) et f2(T) Fit sont des fonctions quadratiques de la température (T).

4. Procédé suivant la revendication 1, dans lequel les fonctions f1(T) et f2(T) Fit sont des fonctions exponentielles de la température (T).

5. Procédé suivant l'une des revendications 1 à 4, dans lequel on déduit des deux signaux S1 et S2 normés en intensité, suivant les deux équations (1) et (2) mentionnées, de plus une valeur (TX) de mesure de température pour la température T.

6. Dispositif pour mesurer une grandeur (X) alternative électrique comportant

a) des moyens (4, 34) pour envoyer de la lumière (L) de mesure polarisée dans un dispositif (3) capteur qui est soumis à l'influence de la grandeur (X) alternative et qui, en fonction de la grandeur (X) alternative électrique, fait varier la polarisation de la lumière (L) de mesure qui y passe,
b) un analyseur (7) pour séparer la lumière (L) de mesure après qu'elle soit passée au moins une fois dans le dispositif (3) capteur en deux signaux (L1, L2) lumineux partiels polarisés linéairement ayant des plans de polarisation différents,
c) des convertisseurs (12, 22) opto-électriques pour convertir les deux signaux (L1, L2) lumineux partiels chacun en un signal (I1, I2) d'intensité électrique,
d) des moyens (13, 23) pour normer qui forment pour chacun des deux signaux (I1, I2) d'intensité un signal S1 et S2 normé en intensité qui correspond à un quotient d'une composante de signal alternatif sur une composante de signal continu du signal (I1, I2) d'intensité associé ;
e) des moyens (20) d'exploitation pour déduire des deux signaux S1 et S2 normés en intensité, un signal M de mesure dans une grande mesure indépendant de la température (T) pour la grandeur (X) alternative électrique, suivant les deux équations

$$S1 = f1(T) * M \qquad (1)$$

$$S2 = f2(T) * M \qquad (2)$$

f1(T) et f2(t) étant des fonctions prescrites de la température T.

7. Dispositif suivant la revendication 6, dans lequel les fonctions f1(T) et f2(T) sont des fonctions linéaires ou quadratiques de la température T.

8. Dispositif suivant la revendication 6 ou suivant la revendication 7, dans lequel l'analyseur est relié du point de vue optique aux convertisseurs (12, 22) opto-électriques par l'intermédiaire d'un guide (10, 20) d'onde de lumière respectif pour chaque signal (L1, L2) lumineux partiel.

9. Dispositif suivant la revendication 8, dans lequel les guides (10, 20) d'onde de lumière sont des fibres multimode.

10. Dispositif suivant l'une des revendications 6 à 9, dans lequel le dispositif (3) capteur et l'analyseur (7) sont reliés l'un à l'autre du point de vue optique par l'intermédiaire d'une fibre optique maintenant la polarisation et servant à transmettre la lumière (L) de mesure découplée du dispositif (3) capteur.

FIG 1

FIG 2

FIG3

**FIG 4**